# EUROPÄISCHE PATENTANMELDUNG

(11) **EP 2 234 175 A2**
(43) Veröffentlichungstag der Anmeldung: **29.09.2010**
(21) Anmeldenummer: 10156067.0
(22) Anmeldetag: 10.03.2010
(51) Int. Cl.: H01L 31/048, H01L 31/18, B32B 38/00, B32B 38/18, B32B 17/10

(54) **Vorrichtung und Verfahren zum Kaschieren von Solarmodulen**

(30) Priorität: 27.03.2009 EP 09156517
(71) Anmelder: Komax Holding AG, 6036 Dierikon (CH)
(72) Erfinder: Kaufmann, Stefan, 5000, Aarau (CH); Grätzer, Walter, 8840, Einsiedeln (CH)
(74) Vertreter: Blöchle, Hans

(57) **Zusammenfassung**

Die Erfindung betrifft eine Vorrichtung (100) zum Kaschieren eines Solarmoduls (48), mit einer Zuschneide-Einheit (200) zum Zuschneiden von Laminier-Folie (2), mit einer Zuschneide-Einheit-Haltevorrichtung zum Halten der Laminier-Folie (2) in einer Zuschneide-Position (ZP) beim Zuschneiden mit mindestens einem Messer (14), und einer Auflege-Einheit (900) zum Auflegen der zugeschnittenen Laminier-Folie (2) in einer Auflege-Position (AP) mit einer Auflege-Einheit-Haltevorrichtung auf eine Trägerplatte (1), wobei die Vorrichtung (100) eine Trenn-Einheit (300) zum Abtrennen eines Stückes Laminier-Folie (2) von einem Folien-Abroller (6) und eine Auszugs-Einheit (500) zum Ausziehen der Laminier-Folie (2) auf einen Schneidetisch (700) in die Zuschneide-Position (ZP) umfasst.

## Beschreibung

Die vorliegende Erfindung betrifft eine Vorrichtung und ein entsprechendes Verfahren mit dieser Vorrichtung zum sogenannten Kaschieren bzw. Laminieren von Solarmodulen. Die Erfindung betrifft insbesondere eine Fertigungslinie zum Zuschneiden und Aufbringen bzw. Auflegen von Laminier-Folien bei der Herstellung von Solarmodulen.

Grundsätzlich werden Photovoltaik- bzw. Solarmodule hergestellt, indem auf eine frontseitige Trägerplatte, z.B. aus Glas, von ihrer Rückseite her, d.h. mit der optisch aktiven Seite nach unten, die einzelnen Solarzellen und deren Verbindungskontakte (Strings) oder mit den lichtempfindlichen Substanzen beschichtete Folien mit einer rückseitigen Deckplatte oder Deckfolie gefasst (kaschiert) werden. Direkt anschliessend oder in einem späteren Arbeitsgang werden die aufeinandergelegten Schichten durch Unterdruck und Erwärmung laminiert.

So werden beispielsweise Laminier-Folien aus EVA (Ethylenvinylacetat), PVB (Polyvinylbutyral) oder Ionomeren (thermoplastische Kunststoffe, wie z.B. Nafion) und Rückseitenfolien aus Tedlar (Polyvinylfluorid) verwendet. Diese Folien werden auf Lieferrollen angeliefert und auf das benötigte Mass zugeschnitten.

Bei der Herstellung von Dickschicht-Solarmodulen, bei denen überwiegend kristallines Silizium verwendet wird, ist die geforderte Auflege- und Schneidegenauigkeit gering, weil die nach der Laminierung überstehende Folie einfach weggeschnitten werden kann. Demzufolge sind auch die Genauigkeitsanforderungen an herkömmliche Folienschneidemaschinen gering.

Die Genauigkeitsanforderungen sind jedoch bedeutend höher bei der Herstellung von Dünnschicht-Solarmodulen, bei denen amorphes Silizium oder Cadmiumtellurid (CdTe) oder Kupfer-Indium-Diselenid (CIS) verwendet wird. Insbesondere bei Dünnschicht-Solarmodulen kommt der dauerhaften Kapselung eine besondere Bedeutung zu, weil eindringende Feuchtigkeit und dadurch auftretende Korrosion die Lebensdauer des Moduls stark verkürzen kann und auch deren Wirkungsgrad durch ungewollte elektrische Verbindungen der stromdurchflossenen Bauteile verschlechtern kann. Als Schutz vor eindringender Feuchtigkeit werden beispielsweise die frontseitige Trägerplatte bzw. Glasplatte und die rückseitige Kaschierung bzw. Deckplatte (in den meisten Fällen erstrecht wieder eine Glasplatte) mit einer Randversiegelung (sogenanntes Sealing, z.B. mit Butyl) abgedichtet. Die Laminier-Folie muss demzufolge passgenau zwischen die Versiegelungsstreifen gelegt werden, sodass einerseits nach der erfolgten Laminierung keine Luftblasen vorhanden sind und andererseits die Laminier-Folie nicht auf dem Versiegelungsstreifen zu liegen kommt, wodurch eine zuverlässige und langzeitstabile Dichtigkeit beeinträchtigt werden würde.

Das Auftragen der Versiegelungsstreifen bzw. Butylbänder ist je nach Applikation (Tape oder Hot Melt) mit grossen Ungenauigkeiten (bis zu +/- 3 mm) verbunden und auch die Glas-Trägerplatte weist Toleranzen bis zu +/- 1 mm auf. Das Schneiden der Laminier-Folie und deren Auflegen auf den Butylrahmen unterliegen jeweils einer Toleranz von +/- 1 mm, sodass sich insgesamt eine Ungenauigkeit von +/- 6 mm ergibt.

Die Laminier-Folie kann je nach Material und Dicke Toleranzen oder sogar einen absichtlich freigelassenen Spalt durch seine spezifische Fliesslänge und flächige Ausdehnungsfähigkeit beim Laminiervorgang ausgleichen, diese Materialeigenschaften sind jedoch beschränkt. Und Letzteres umso mehr, je dünner die Laminier-Folie ist. Im Hinblick auf Materialeinsparung und Ressourcenschonung ist es jedoch wünschenswert, Laminier-Folien zu verwenden, die möglichst dünn sind. Demzufolge kommt der Schneide- und Auflegegenauigkeit eine umso grössere Bedeutung zu.

Konventionelle Folienschneider, die für das Zuschneiden von Folien für Dickschicht-Solarmodule (kristalliner Bereich) zur Anwendung gelangen, bieten zu wenig Genauigkeit zur Anwendung bei der Herstellung von Dünnschicht-Solarmodulen. Auch die konventionellen Folienschneider aus anderen Fachgebieten, die zum Beispiel in der Automobilindustrie zum Herstellen laminierter Glasscheiben zum Einsatz kommen, bieten zu wenig Genauigkeit. Ein entsprechendes Beispiel ist aus der Patentanmeldung EP 0 319 251 A2 bekannt. Dieses Dokument beschreibt eine Vorrichtung und ein Verfahren zum Laminieren von Glas. Insbesondere geht es um das Platzieren einer Zwischenlage zwischen zwei Glasscheiben, die durch Laminieren miteinander verbunden werden sollen. EP 0 319 251 A2 schlägt vor mit elektrostatischer Aufladung zu arbeiten, um die Zwischenlage zu positionieren. Ein solcher Ansatz kommt für die Herstellung von empfindlichen Solarmodulen nicht in Frage. Elektrostatische Aufladungen werden bei der Herstellung von Solarmodule bewusst vermieden.

In der US-Patentanmeldung US 2006/0219364 geht es um das Zuführen von Keramikgrünlingen mittels eines Tragfilms, das Zuschneiden der Keramikgrünlinge und das anschliessende Laminieren der zugeschnittenen Grünlinge. Dieses Verfahren lässt sich nicht auf das Laminieren von Solarmodulen übertragen, da diese nicht mittels eines Tragfilms zugeführt und zugeschnitten werden.Als Alternative werden sogenannte Plotter verwendet, die mittels oszillierender Messer eine höhere Schnitt- und Schneidegenauigkeit erreichen. Die Auflegegenauigkeit der zugeschnittenen Laminier-Folie auf die Trägerplatte jedoch bleibt unverändert gering.

Zudem arbeiten diese Systeme mit Schneidematten. Da solche Systeme ca. alle 30 Sekunden oder noch schneller eine Folie zuschneiden und das im 24/7-Betrieb, sind die Schneidematten durch die hohe Beanspruchung und die immerwährend gleiche Geometrie in kürzester Zeit zerstört. Ihr Ersatz führt zu hohen Kosten und Maschinenstillstandzeiten. Die Alternative, die auszuschneidende Laminier-Folie immer um ein paar Millimeter zu verschieben und so die Schneidematte besser auszunutzen, führt aufgrund des daraus resultierenden grösseren Verschnitts der Laminier-Folien ebenfalls zu erheblichen Kosten.

Die Aufgabe der vorliegenden Erfindung ist, eine Vorrichtung und ein entsprechendes Verfahren unter Anwendung dieser Vorrichtung bereit zu stellen, mit denen eine höhere Genauigkeit erreicht werden kann, das Schneiden generell optimiert ist - indem beispielsweise im Speziellen keine Schneidematten mehr verwendet werden, weniger Materialverbrauch und -verschleiss auftritt und somit die Kosten gesenkt sind.

Die Lösung der Aufgabe besteht zunächst in der Eliminierung der Ungenauigkeit, die durch die Übergabe einer Haltevorrichtung für die Laminier-Folie beim Schneidevorgang an einen Greifer für die zugeschnittene Laminier-Folie beim Auflege-Vorgang auftritt. Die erfindungsgemässe Vorrichtung bzw. das erfindungsgemässe Verfahren sieht nämlich vor, dass die Haltevorrichtung für das Zuschneiden entfällt, indem der Greifer für das Auflegen das Halten der Laminier-Folie beim Schneiden übernimmt. Dadurch entfällt auch die Quelle für Ungenauigkeiten, die durch die Übergabe der Laminier-Folie vom Bearbeitungsprozess Zuschneiden zum Bearbeitungsprozess Auflegen auftreten.

Des Weiteren sieht die erfindungsgemässe Vorrichtung bzw. das erfindungsgemässe Verfahren einen Schneidevorgang vor, bei dem keine Schneidematten mehr benötigt werden. Hierfür ist eine Teilvorrichtung der gesamten Vorrichtung vorgesehen, die mittels einer Auszugs-Einheit die Laminier-Folie in einer definierten Grösse von der Lieferrolle auszieht, abtrennt und positionsgenau auf einen Schneidetisch platziert. Diese positionsgenaue Platzierung bzw. die Abmessungen des Schneidetisches sind so gewählt, dass die vorgeschnittene Laminier-Folie mit einer nur geringen Überlappung über die Kanten des Schneidetisches hinaus aufgelegt wird. Die inhärente Strukturfestigkeit der Laminier-Folie einerseits und andererseits eine Fixation der Laminier-Folie am Schneidetisch - beispielsweise durch Ansaugen mit einem Vakuum - erlauben so einen freien Schnitt quasi "in der Luft" an der Schneidetischkante entlang, der ohne den Gegendruck einer Schneidematte erfolgen kann. Der kostenintensive Einsatz der Schneidematten entfällt somit und der Verschleiss der Schneidemesser nimmt deutlich ab, weil sie nur noch die relativ weiche Laminier-Folie schneiden und nicht mehr mit einer möglichst harten Schneidematte in Berührung kommen. Darüber hinaus gewährleistet die positionsgenaue und nur geringe Überlappung der Laminier-Folie auf dem Schneidetisch einen materialsparenden Anfall von Verschnitt.

Der Schneidevorgang der Laminier-Folie auf dem Schneidetisch ist weiterhin erfindungsgemäss dadurch verbessert, indem der sie haltende Greifer - vorzugsweise ein Vakuum-Greifer - einen die Aussenkontur seiner Auflagefläche umlaufenden Rahmen aufweist, der identische Aussenabmessungen wie die Auflagefläche des Schneidetisches hat. Das zuzuschneidende Stück Laminier-Folie wird somit nicht nur beispielsweise von Saugnäpfen des Greifers gehalten, sondern zusätzlich mit diesem Rahmen geklemmt bzw. von oben im Bereich aller vier Aussenkanten auf die Auflagefläche des Schneidetisches angedrückt.

Eine weitere Optimierung des Schneidevorgangs erfolgt durch die erfindungsgemässe Anordnung von vier Schneidemessern, die gleichzeitig alle vier Kanten bearbeiten. Hierfür sind vier Schneideköpfe an je einer Schiene eines Rahmens angeordnet. Die vier Schneideköpfe sind vorzugsweise beim Nichtbetrieb in einer Parkposition geparkt und fahren beim Betrieb mittels je eines eigenen Antriebs eine jeweilige Führungsschiene entlang. Nach beendetem Schneidevorgang - gesteuert beispielsweise durch einen schubumkehrenden Endschalter oder Sensor - fahren die Schneideköpfe in ihre Parkposition zurück.

Auf diese Weise ist eine Optimierung des gesamten Schneidevorgangs, der aus vier Einzel-Schneidvorgängen besteht, sowohl hinsichtlich seiner Schnelligkeit, aber auch hinsichtlich seiner Genauigkeit realisiert.

Die Schneideköpfe führen ihre Schneidebewegung vorzugsweise simultan aus, mittels einer programmierbaren Steuerung. Es ist jedoch auch eine Schaltung realisierbar, bei der der Start eines ersten Schneidekopfes den Start eines zweiten Schneidekopfes, dieser Start wiederum den Start eines dritten Schneidekopfes und dieser Start wiederum den Start eines vierten Schneidekopfes triggert.

Des Weiteren sind die Schneideköpfe vorzugsweise mit einer von Hand betätigbaren Spindel oder einem vorzugsweise elektrischen Antrieb zum Verstellen der Schneidemesser ausgestattet.

Die Schneidemesser sind vorzugsweise als rotierende kreisförmige Schneidescheiben ausgestaltet. Es kommen jedoch auch translatorisch bewegte feste oder oszillierende Klingen oder aber auch Laser in Betracht.

Optional und zur Vermeidung allfälliger Maschinenstillstandzeiten, ist für die Schneidemesser in ihrer Parkposition eine Schleifvorrichtung vorgesehen, die mit einer weiteren, senkrecht wirkenden Verstellung kombiniert ist. D.h., dass ein sich durch den Betrieb, aber auch durch das Nachschleifen verkleinernder Durchmesser der Schneidescheibe nachjustierbar ist, bis ein Sensor an dem Schneidekopf einen zu klein gewordenen Durchmesser signalisiert.

Wie schon erwähnt, wird die Laminier-Folie erfindungsgemäss einerseits von der Saugwirkung des Schneidetisches, aber andererseits von dem Greifer auf dem Schneidetisch gehalten, der anschliessend das Auflegen der zugeschnittenen Laminier-Folie auf die Trägerplatte ausführt. An dem Schneidetisch oder an dem Greifer können somit weitere Schneidemesser oder Laser oder eine Stanzvorrichtung integriert sein, die ein Abrunden oder ein weitergehendes Zuschneiden über die Form eines schlichten Quadrats oder Rechtecks hinaus ausüben.

Es gibt Solarmodule, die besondere Kontaktierungsvarianten mittels hierfür vorgesehener Löcher bzw. Ausnehmungen vorsehen. Die vorgängig beschriebenen zusätzlichen Schneidemesser, Laser oder Stanzvorrichtungen können optional auch für das Anbringen der erforderlichen Löcher bzw. Ausnehmungen eingesetzt werden, wobei diese Vorrichtungen sowohl an dem Schneidetisch, als auch an dem Greifer oder beidem angeordnet sein können.

Gemäss einer weiteren Ausgestaltungsvariante sind die Schneideköpfe bzw. die Schienen, an denen sie entlanglaufen, an den Seitenwänden des Schneidetisches integriert. Der aus den Schienen gebildete Rahmen einer Zuschneide-Einheit oberhalb des Schneidetisches entfällt somit und ergibt einen freien Zugriff des Greifers auf die zugeschnittene Laminier-Folie, ohne dass die Zuschneide-Einheit vorher verfahren werden müsste oder die Laminier-Folie von dem Greifer durch den Rahmen hindurch herausgehoben werden müsste. Bei dieser Ausgestaltungsvariante würde somit grundsätzlich und vorteilhafterweise auch die Notwendigkeit einer ausserhalb der zugeschnittenen Fläche der Laminier-Folie liegenden Parkposition für die Schneideköpfe entfallen.

Damit bei letztgenannter Ausgestaltungsvariante die Schneideköpfe der konstruktiven Einfachheit halber an den Seitenflächen des Schneidetisches direkt von unten die zuzuschneidende Laminier-Folie schneiden, die Laminier-Folie sich jedoch durch den Druck der Schneidemesser nicht hochhebt, ist der Greifer vorzugsweise stempelförmig ausgestaltet, mit einer passgenauen Auflagefläche, die wiederum somit eine einen präzisen Schnitt unterstützende Kante ergibt.

Der Schneidetisch, oder aber auch der Greifer ist vorzugsweise so ausgebildet, dass eine plane Fläche Öffnungen aufweist, die mit porösem und griffigem Material gefüllt sind. An der Rückseite der Öffnungen ist vorzugsweise ein Vakuum angelegt, sodass die Laminier-Folie an die Saugstücke aus porösem Material angesaugt wird. Optional hierzu ist auch eine Ausgestaltungsvariante mit klassischen Saugnäpfen realisierbar, oder aber eine, bei der auf die Saugstücke oder Saugnäpfe verzichtet wird und die Fläche des Schneidetisches bzw. des Greifers insgesamt eine Saugglocke bildet. Es muss hierbei beachtet werden, dass die Grösse der Saugglocke bzw. die Ansaugkraft die Laminier-Folie nicht übermässig wölbt. Die hiermit offenbarten Halte-Varianten der Laminier-Folie, sei es mit Saugnäpfen oder Saugstücken oder einer Saugglocke sind sowohl für den Schneidetisch, als auch für den (Vakuum-)Greifer realisierbar.

Die erfindungsgemässe Vorrichtung weist des Weiteren eine Auszugs-Einheit auf, die mit einer Trenn-Einheit kombiniert ist. Diese beiden Einheiten dienen dazu, von der Lieferrolle ein adäquates, später zuzuschneidendes Stück Laminier-Folie zu greifen, abzutrennen und auf den Schneidetisch zu ziehen.

Die Trenn-Einheit verfügt, wie die Zuschneide-Einheit auch, über einen vorzugsweise elektrisch angetriebenen Schneidekopf, der auf einer Schiene in Y-Richtung verfahrbar ist. Die Y-Richtung ist quer zu der Abrollrichtung der Laminier-Folie von der Lieferrolle. Auch dieser Schneidekopf der Trenn-Einheit weist eine rotierende Schneidescheibe, oder eine feststehende oder oszillierende Klinge oder einen Laser als Messer auf. Die Trenn-Einheit verfügt vorzugsweise des Weiteren über einen Rollenantrieb, mit dem ein Vorschub der Laminier-Folie erfolgt.

Die Trenn-Einheit verfügt des Weiteren über eine Klemmschiene, die erfindungsgemäss zwei Aufgaben erfüllt: Einerseits fasst und hält die Klemmschiene mittels vorzugsweise pneumatisch angetriebener Hebel die Laminier-Folie für einen sauberen Schnitt. Andererseits jedoch bördelt die Trenn-Einheit nach erfolgtem Schnitt die Schnittkante der Laminier-Folie auf, bzw. hebt sie auch nur an, indem - auch wieder vorzugsweise pneumatisch - ein Hochhalter die Schnittkante der Laminier-Folie von unten mit einer abgeschrägten Stirnfläche hochdrückt. Die abgeschrägte Stirnfläche des Hochhalters kann in einem Winkel von 5 bis 45 Grad geneigt sein, weist vorzugsweise jedoch einen Winkel von 30 Grad auf, sodass nach erfolgter Bördelung bzw. nach erfolgtem Hochhalten eine optimale Übernahme des vorgeschnittenen Stückes der Laminier-Folie durch Greifer der Auszugs-Einheit erfolgen kann.

Vorzugsweise mehrere Greifer der Auszugs-Einheit sind ebenfalls schräg in einem korrespondierenden Winkel von 5 bis 45 Grad, vorzugsweise von 30 Grad an einem Balken der Auszugs-Einheit befestigt. Die Greifer sind vorzugsweise pneumatisch betätigt und können synchron durch einen elektrischen Antrieb in X-Richtung durch Verschieben des Balkens längs bewegt werden. Vorzugsweise können die Greifer auch in der Ebene, die durch ihre Winkelstellung gebildet ist, d.h. entlang ihrer Längsachse, mittels einer pneumatischen Schlitteneinheit verstellt werden. Die Greifer weisen Greifer-Backen auf, die sich vorzugsweise ebenfalls pneumatisch schliessen und öffnen lassen.

Eine hierzu alternative Ausgestaltungsvariante sieht vor, dass die Greifer der Auszugs-Einheit die Laminier-Folie direkt an der Lieferrolle greifen, noch vor dem Abtrennen. Sie ziehen die Laminier-Folie auf ein Schneidepult mit der Schnittkante des vorhergehenden Folienstücks bis an einen oder mehrere Anschläge, Endschalter oder Sensoren heran. Sobald diese - vorzugsweise einstellbare - Endstellung erreicht ist, wird von einem Schneidekopf an dem Schneidepult in einem definierten und vorzugsweise auch einstellbaren Abstand das zu bearbeitende Stück Laminier-Folie abgetrennt. Es wird also nicht wie bisher erst die vordere Kante des Folienstückes, sondern gleich die hintere Kante (zur Lieferrolle hin) des Folienstückes geschnitten. Dieses Folienstück kommt somit auf dem Schneidepult zu liegen und kann eine eventuelle Spannung wieder verlieren, die durch den Abzug von der Lieferrolle aufgetreten sein kann. Anschliessend wird das weiter zu verarbeitende Stück Laminier-Folie nicht von der bisher offenbarten Auszugs-Einheit auf den Schneidetisch gezogen, sondern von dem (Vakuum-)Greifer aufgenommen, der später die Laminier-Folie beim endgültigen Zuschneiden hält und noch später auf die Trägerplatte auflegt. Diese Ausgestaltungsvariante hat gegenüber den bisher offenbarten Ausgestaltungsvarianten einerseits den Vorteil, dass die bisher offenbarte Auszugs-Einheit mit schrägen Greifern und der Umbördelungs- bzw. Hochhalteprozess entfallen können und weniger Verschnitt anfällt. Andererseits ist eine weitere Ungenauigkeiten-Quelle eliminiert, indem zusätzlich eine weitere Übergabe weniger stattfindet, nämlich diejenige von der Auszugs-Einheit an den Schneidetisch.

Bei dieser letztbeschriebenen Ausgestaltungsvariante sind die Greifer der Auszugsvorrichtung, die direkt bei der Lieferrolle ansetzt, vorzugsweise als Vakuumzangen ausgestaltet, die die Oberfläche der Laminier-Folie nicht beschädigen. Auf diese Weise kann erreicht werden, dass die Schnittkante vom vorhergehenden Folienstück selbst als endgültige Schnittkante in äusserster X-Richtung verwendet werden kann, also an dieser Kante überhaupt kein Verschnitt mehr anfällt. Das Schneidepult ist vorzugsweise gegenläufig zu einem herausfahrbaren Anschlag an der neuen (Lieferrollen-)Schnittkante in X-Richtung zur Lieferrolle hin verfahrbar, sodass die gegenüberliegende Schnittkante für das Greifen durch die Vakuumzangen frei wird.

Die beschriebenen Ausgestaltungsvarianten sind auch auf eine erfindungsgemässe Vorrichtung bzw. Fertigungslinie reduzierbar, bei der die Laminier-Folie in Form von vorgeschnittenen und gestapelten Blättern angeliefert wird. Dieses kann dann entweder dadurch realisiert sein, indem die bisher beschriebene Auszugseinheit das oberste Blatt Laminier-Folie vom Stapel zieht oder, wie oben beschrieben, der (Vakuum-) Greifer der Auflege-Einheit nicht nur die Haltefunktion beim Zuschneiden, sondern zusätzlich auch das Abholen des obersten Blattes Laminier-Folie vom Stapel ausführt.

Alle offenbarten Ausgestaltungsvarianten beseitigen die Fehlerquellen, die einerseits durch das Zuschneiden selbst und andererseits durch die Übergabe der Laminier-Folie vom Bearbeitungsprozess des Zuschneidens zum Bearbeitungsprozess des Auflegens auftreten. Die beschriebenen Ausgestaltungsvarianten zeigen somit Vorteile auf, die sich in höherer Bearbeitungsgenauigkeit, effizienterer und materialschonender Bearbeitung und somit genaueren und günstigeren Endprodukten äussert.

Eine verbleibende Fehlerquelle hingegen sind die Ungenauigkeiten, die durch die Applikation der Butyl-Versiegelung nach wie vor besteht. Um auch diese zu beseitigen, ist eine Ausgestaltungsvariante einer erfindungsgemässen Vorrichtung denkbar, bei der eine hochauflösende Kamera ein Bild der Trägerplatte mit der applizierten Butyl-Versiegelung aufnimmt. Diese Bildinformation wird rechnerisch an die Steuerung der Zuschneide-Einheit weitergegeben und positioniert die Messer vor dem Zuschneiden der Laminier-Folie exakt und bedarfsgerecht. Insbesondere Messer, die beispielsweise mit einem in X- und Y-Richtung steuerbaren Laserkopf schneiden, wären so in der Lage, eine Laminier-Folie zuzuschneiden, die unter Berücksichtigung einer Dehnungsfuge hochpräzis in einen noch so ungenauen Butyl-Versiegelungsrahmen eingepasst werden kann.

Die erfindungsgemässe Vorrichtung ist vorzugsweise aufgrund einer Verstellbarkeit der relevanten Haltevorrichtungen und Greifer sowohl für das Kaschieren von Dünnschicht-, als auch von Dickschicht-Solarmodulen geeignet.

Weitere oder vorteilhafte Ausgestaltungen einer erfindungsgemässen Vorrichtung bilden die Gegenstände der abhängigen Ansprüche.

Anhand von Figuren wird die Erfindung symbolisch und beispielhaft näher erläutert. Die Figuren werden zusammenhängend und übergreifend beschrieben. Sie stellen schematische und beispielhafte Darstellungen dar und sind nicht massstabsgetreu, auch in der Relation der einzelnen Bestandteile zueinander nicht. Gleiche Bezugszeichen bedeuten gleiche Bauteile, Bezugszeichen mit unterschiedlichen Indices geben funktionsgleiche oder ähnliche Bauteile an.

Es zeigen dabei
Fig. 1 eine schematische Darstellung einer erfindungsgemässen Vorrichtung bzw. Fertigungslinie zum Zuschneiden und Auflegen von Laminier-Folie auf eine Trägerplatte eines Solarmoduls;
Fig. 2 eine schematische Detaildarstellung eines Teils der erfindungsgemässen Vorrichtung;
Fig. 3 eine schematische Detaildarstellung einer erfindungsgemässen Trenn-Einheit;
Fig. 4 eine schematische Detaildarstellung, in partieller Schnittdarstellung, einer erfindungsgemässen Haltevorrichtung der Trenn-Einheit;
Fig. 5 eine schematische Detaildarstellung einer erfindungsgemässen Auszugs-Einheit;
Fig. 6 eine schematische Detaildarstellung, partiell geschnitten, eines erfindungsgemässen Greifers der Auszugs-Einheit;
Fig. 7 eine schematische Darstellung eines erfindungsgemässen Schneidetisches;
Fig. 8 eine schematische Darstellung einer erfindungsgemässen Zuschneide-Einheit;
Fig. 9 eine schematische Detaildarstellung eines erfindungsgemässen Schneidekopfes;
Fig. 10 eine schematische Darstellung eines erfindungsgemässen Vakuum-Greifers;
Fig. 11 eine schematische Detaildarstellung der erfindungsgemässen Haltevorrichtung und des erfindungsgemässen Greifers in geöffnetem Zustand;
Fig. 12 eine schematische Darstellung der erfindungsgemässen Haltevorrichtung und des erfindungsgemässen Greifers in geschlossenem Zustand;
Fig. 13 eine schematische Seitendarstellung des Teils der Vorrichtung, der in Fig. 2 perspektivisch dargestellt wurde, allerdings ohne den Vakuum-Greifer, und des Greifers beim Ausziehen der Laminier-Folie auf den Schneidetisch;
Fig. 14 die schematische Seitendarstellung aus Fig. 13 mit dem Greifer in beendeter Auszugsposition;
Fig. 15 eine schematische Seitendarstellung des Vakuum-Greifers in der Halteposition auf dem Schneidetisch;
Fig. 16 eine schematische und perspektivische Darstellung der Zuschneide-Einheit beim Zuschneiden und
Fig. 17 eine schematische Seitendarstellung des Auflegevorgangs der Laminier-Folie mittels des Vakuum-Greifers auf die Trägerplatte.

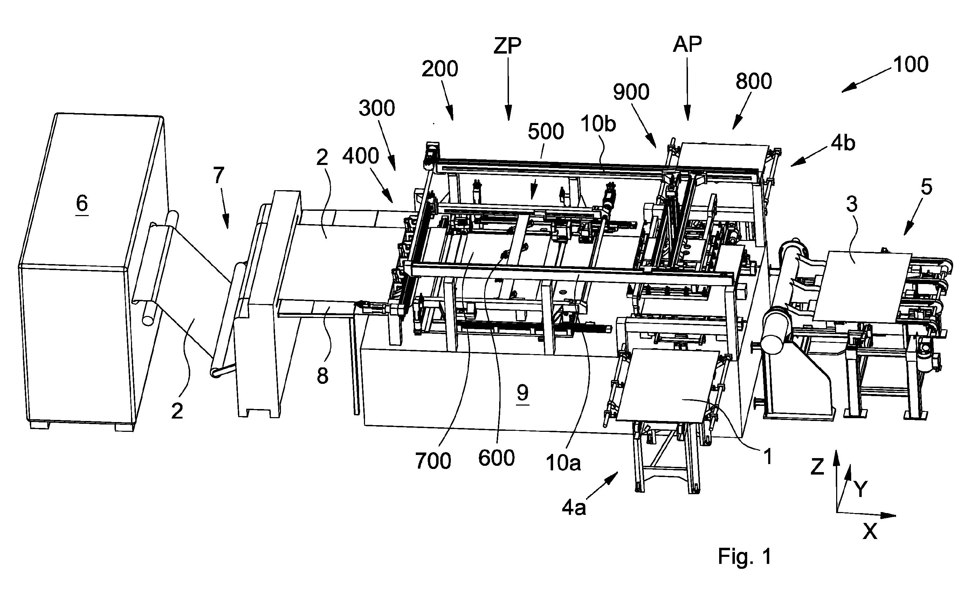

Die Fig. 1 zeigt eine schematische und perspektivische Darstellung einer erfindungsgemässen Vorrichtung 100 bzw. einer Fertigungslinie 100 zum Kaschieren von Solarmodulen, d.h. zum Zuschneiden und Auflegen einer Laminier-Folie 2 auf eine Trägerplatte 1 oder eine Deckplatte, die mit einem Transportsystem 4a der Vorrichtung 100 zugeführt wird. Die Vorrichtung 100 kann eine abgeschlossene Fertigungslinie sein, deren Endprodukt das kaschierte Solarmodul ist, oder in eine weitergehende Fertigungslinie integriert sein, die auch den Laminier-Vorgang des kaschierten Solarmoduls ausführt.

Die Trägerplatte 1 oder die Deckplatte stellt die optisch aktive Seite des späteren Solarmoduls dar und wird von dem Transportsystem 4a auf ihrer Frontseite, d.h. mit ihrer Rückseite nach oben weisend zugeführt. Nicht näher dargestellt ist hierbei ein Versiegelungsrahmen, der beispielsweise aus Butyl auf der Rückseite der Trägerplatte 1 oder der Deckplatte selbst appliziert sein kann.

Nach erfolgtem Zuschneide- und Auflegevorgang der Laminier-Folie 2 auf die Trägerplatte 1 wird eine Deckplatte 3 durch ein Wendemodul 5 darübergelegt. Im Falle der Applikation des Versiegelungsrahmens auf der Deckplatte kann diese mit dem Transportsystem 4a angeliefert werden, die Laminier-Folie 2 aufgelegt werden und anschliessend mit dem Wendemodul 5 die Trägerplatte 1 aufgelegt werden. Das somit kaschierte und versiegelte Solarmodul wird sodann durch ein Transportsystem 4b zu einer nicht näher dargestellten Laminier-Vorrichtung abgeführt.

Die Laminier-Folie 2 wird mit einem Rollen-System 7 aus einem Folien-Abroller 6 abgerollt und kommt auf einem Auflage-Tisch 8 zu liegen. Der Auflage-Tisch 8 ist so dimensioniert, dass eine Trenn-Einheit 300 ein ausreichend grosses Folienstück für die spätere Bearbeitung abtrennt, indem eine Haltevorrichtung 400 die Laminier-Folie 2 hält und die Trenn-Einheit 300 in Y-Richtung schneidet.

Eine Auszugs-Einheit 500 zieht mit Greifern 600 anschliessend das Stück Laminier-Folie 2 über einen Schneidetisch 700. Nicht nur dieser Schneidetisch 700, sondern auch eine Zuschneide-Einheit 200 und ein Vakuum-Greifer 800 sind auf einem Sockelgestell 9 angeordnet, das Führungsschienen 10a und 10b aufweist. Letzteren entlang ist der Vakuum-Greifer 800 so verschiebbar angeordnet, dass er eine Zuschneide-Position ZP oberhalb des Schneidetisches 700 einnehmen kann - vorzugsweise mit Sensoren oder Endschaltern gesteuert.

Die auf dem Schneidetisch 700 aufliegende Laminier-Folie 2 wird sodann sowohl von dem Schneidetisch 700 selbst, als auch von dem Vakuum-Greifer 800 gehalten, der nach Erreichen der horizontalen Position (Verstellung in X-Richtung) oberhalb des Schneidetisches 700 auch vertikal (Verstellung in Z-Richtung) verstellbar ist. Die Zuschneide-Einheit 200 schneidet sodann die Laminier-Folie 2 zu und im Folgenden wird gemäss eines Aspekts der vorliegenden Erfindung das Halten der zugeschnittenen Laminier-Folie 2 durch den Vakuum-Greifer 800 beibehalten. Demzufolge findet keine weitere Übergabe an eine separate Auflege-Vorrichtung statt, denn der Vakuum-Greifer 800 verfährt mit der zugeschnittenen Laminier-Folie 2 in X-Richtung an den Führungsschienen 10a und 10b in eine Auflege-Position AP oberhalb der parat liegenden Trägerplatte 1. Die Laminier-Folie 2 beschreibt somit im Laufe ihrer Bearbeitung innert der Vorrichtung 1 einen Weg von der Zuschneide-Position ZP zu der Auflege-Position AP, bei dem sie von dem Vakuum-Greifer 800 gehalten ist.

Die Trägerplatte 1 an der Auflege-Position AP, das Zuführ-Transportsystem 4a, das Abführ-Transportsystem 4b und der kombiniert einsetzbare Vakuum-Greifer 800 bilden eine Auflege-Einheit 900.

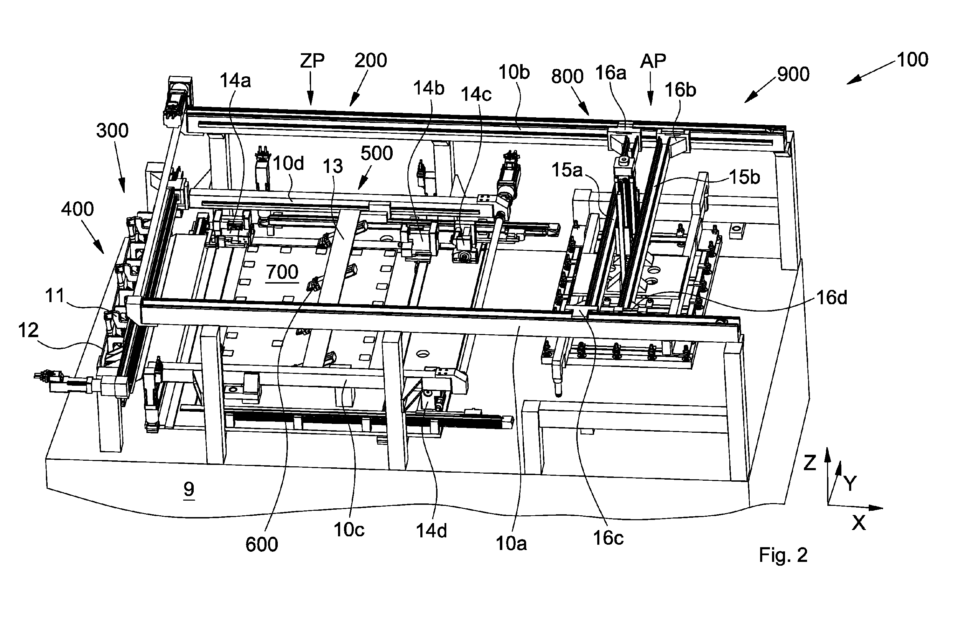

Die Fig. 2 zeigt, der besseren Ersichtlichkeit halber, nur die Trenn-Einheit 300, die Auszugs-Einheit 500, die Zuschneide-Einheit 200 und die Auflege-Einheit 900, wobei die beiden Letzteren erfindungsgemäss beide von dem Vakuum-Greifer 800 bedienbar sind. Die Trenn-Einheit 300 weist vorzugsweise mehrere Haltevorrichtungen 400 auf, die mit einer jeweiligen Hebelvorrichtung 11 eine gemeinsame Klemmschiene 12 betätigen, vorzugsweise pneumatisch, zum Zweck des Haltens der Laminier-Folie beim Abtrennvorgang.

Des Weiteren ist die Auszugs-Einheit 500 dargestellt, mit mehreren an einem Balken 13 angeordneten Greifern 600. Der Balken 13 ist in Führungsschienen 10c und 10d in der X-Richtung verschiebbar. Des Weiteren zeigt die Fig. 2 die Zuschneide-Einheit 200, die oberhalb des Schneidetisches 700 angeordnet ist und vorzugsweise vier Schneideköpfe 14a-14d umfasst, die in einer jeweiligen Parkposition stehend dargestellt sind. Letztere ist vorteilhaft, um Kollisionen zwischen den Schneideköpfen 14a-14d zu vermeiden.

Der Vakuum-Greifer 800 ist in der Auflege-Position AP dargestellt, allerdings wurde in dieser Ansicht auf die Darstellung der Trägerplatte bzw. des Transportsystems verzichtet. Der Vakuum-Greifer 800 weist zwei Streben 15a und 15b auf, die mit Führungselementen 16a und 16b in der Führungsschiene 10b und mit entsprechenden Führungselementen 16c und 16d in der Führungsschiene 10a laufen.

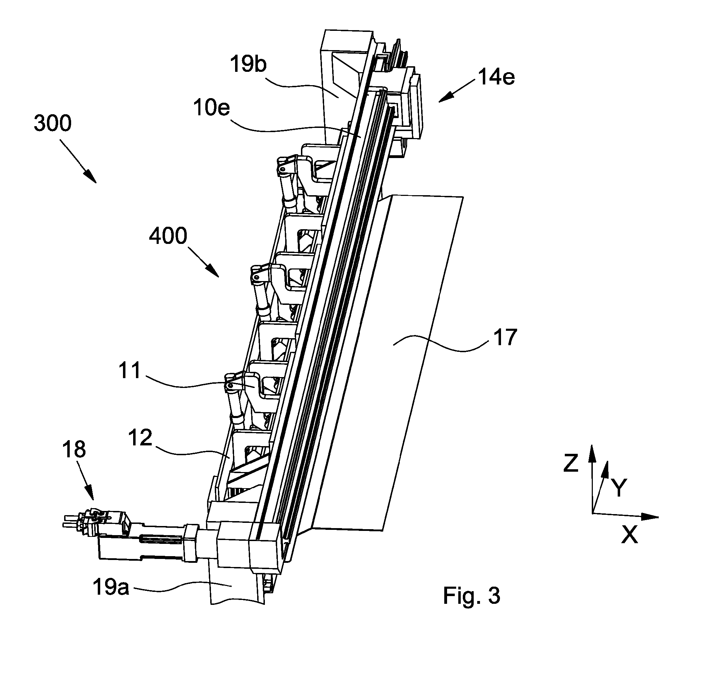

In der Fig. 3 ist die Trenn-Einheit 300 im Detail gezeigt. An zwei Trägern 19a und 19b ist eine Führungsschiene 10e angeordnet, an der ein Schneidekopf 14e in Y-Richtung vorzugsweise motorisch mit einem Motor 18 angetrieben verfahrbar ist. Der Schneidekopf 14e kann eine rotierende Schneidescheibe, eine feststehende oder oszillierende Klinge oder einen Laser aufweisen. Die Laminier-Folie wird von links durch die Trenn-Einheit 300 geführt und von einem Leitblech 17 weitergeleitet. Beim Abtrennvorgang mittels des Schneidekopfes 14e wird die Laminier-Folie gleichzeitig von der gemeinsamen Klemmschiene 12 gehalten. Die Klemmschiene 12 ist durch drei dargestellte Haltevorrichtungen 400 mit jeweiligen Hebelvorrichtungen 11 vorzugsweise pneumatisch betreibbar.

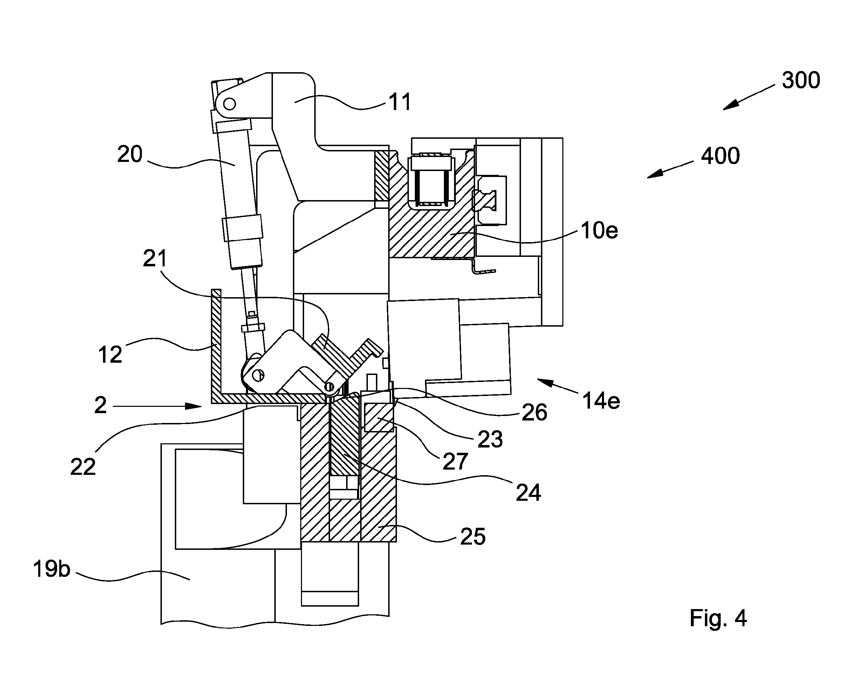

Die Fig. 4 zeigt den Aufbau der Haltevorrichtung 400, indem ein Schnitt in die Trenn-Einheit 300 aus Fig. 3 zwischen zwei Haltevorrichtungen 400 gelegt wurde. Somit sind das Klemmstück 12 und die Führungsschiene 10e schraffiert dargestellt, aber auch ein Niederhalter 21 und ein Hochhalter 24, der in einem Steg 25 eingebettet ist. Der Steg 25 verläuft, wie die Führungsschiene 10e auch, zwischen den Trägern 19a und 19b, von denen in dieser Schnittdarstellung nur der Träger 19b ersichtlich ist.

Des Weiteren ist aus der Fig. 4 ersichtlich, dass ein Kolben 20 an der Hebelvorrichtung 11 angeordnet ist, der einerseits die Klemmschiene 12 auf die Laminier-Folie 2 niederdrückt, die durch eine Führungsöffnung 22 eingeführt ist. Die Laminier-Folie 2 liegt somit vorerst plan auf einem Schneidebalken 27 auf und kann von einer rotierenden Schneidescheibe 23 des Schneidekopfes 14e abgeschnitten werden. Andererseits jedoch, nach durchgeführtem Schnitt, betätigt der Kolben 20 auch den Niederhalter 21, der gegen den Druck des Hochhalters 24 - bzw. gegen eine angewinkelte Stirnfläche 26 des Hochhalters 24 - eine Bördelung der Laminier-Folie 2 ergibt, die in etwa dem Winkel der Stirnfläche 26 entspricht. Die Klemmschiene 12 ist unabhängig vom Niederhalter 21 bewegbar. Dieses ist notwendig, damit die Laminier-Folie 2 beim Hochbiegen fixiert ist.

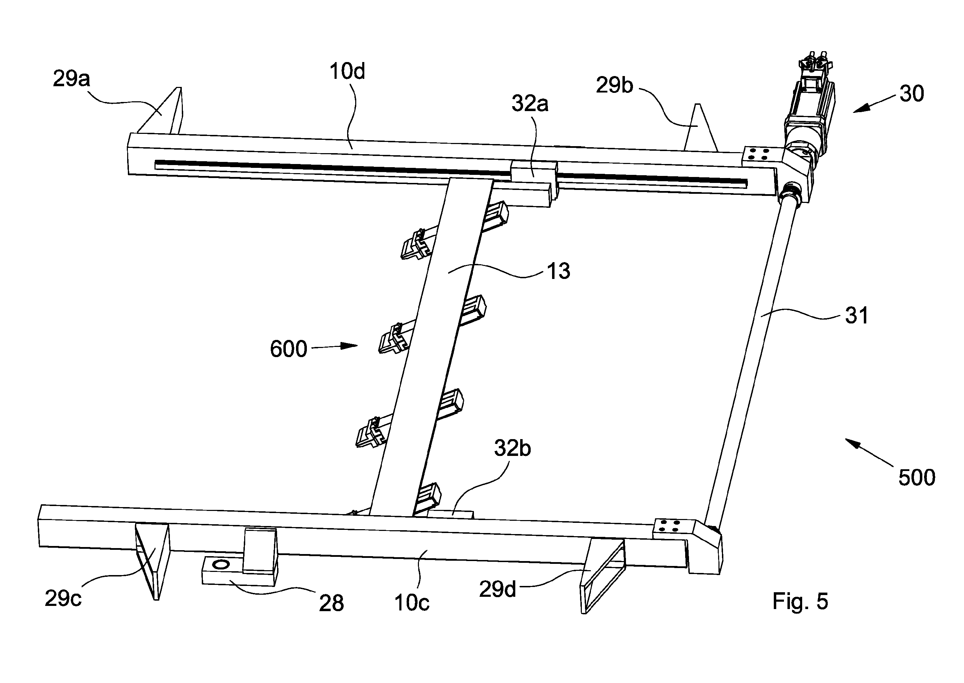

Die Fig. 5 zeigt die Auszugs-Einheit 500. An dem Balken 13 sind beispielsweise vier Greifer 600 in einem Winkel angeordnet, der vorhin beschriebenem Bördelungswinkel der Laminier-Folie entspricht. Er beträgt in etwa 30 Grad. Ein Antrieb 30 und eine Verbindungswelle 31 gewährleisten eine synchrone Verstellbarkeit des Balkens 13 mittels einem Führungsschuh 32a in der Führungsschiene 10d und einem entsprechenden Führungsschuh 32b in der Führungsschiene 10c. Der Antrieb 30 ist vorzugsweise elektrisch ausgestaltet und eine synchrone Betätigung der Greifer 600 pneumatisch. Die Auszugs-Einheit 500 weist des Weiteren eine Zentriervorrichtung 28 und Anschläge 29a-29d auf.

In der dargestellten Form ist die Auszugs-Einheit 500 als eine lineare Schlitteneinheit ausgestaltet. Dieses kann unter Umständen insofern nachteilig sein, als dass nach erfolgter Auszugsbewegung die Greifer 600 die Laminier-Folie wieder loslassen müssen, um anschliessend in der umgekehrten X-Richtung wieder in eine Ausgangsposition für das nächste Stück Laminier-Folie zurückzukehren. Diese Rückstellbewegung kann jedoch einem weitergehenden Bearbeitungsschritt in Form des Herabsenkens des Vakuum-Greifers im Wege stehen. Somit wird hiermit auch eine Ausgestaltungsvariante offenbart, bei der die Auszugs-Einheit 500 in kreisförmig oder oval ausgestalteten Führungsschienen 10c und 10d in ihre Ausgangsposition zurückgeführt wird. Im Rahmen dieser Offenbarung soll auch eine Ausgestaltungsvariante liegen, bei der die Greifer 600 nach erfolgtem Auszug der Laminier-Folie in Y-Richtung auseinandergeschoben werden und einen Rückweg ausserhalb des Aktionsradius des Vakuum-Greifers linear beschreiben.

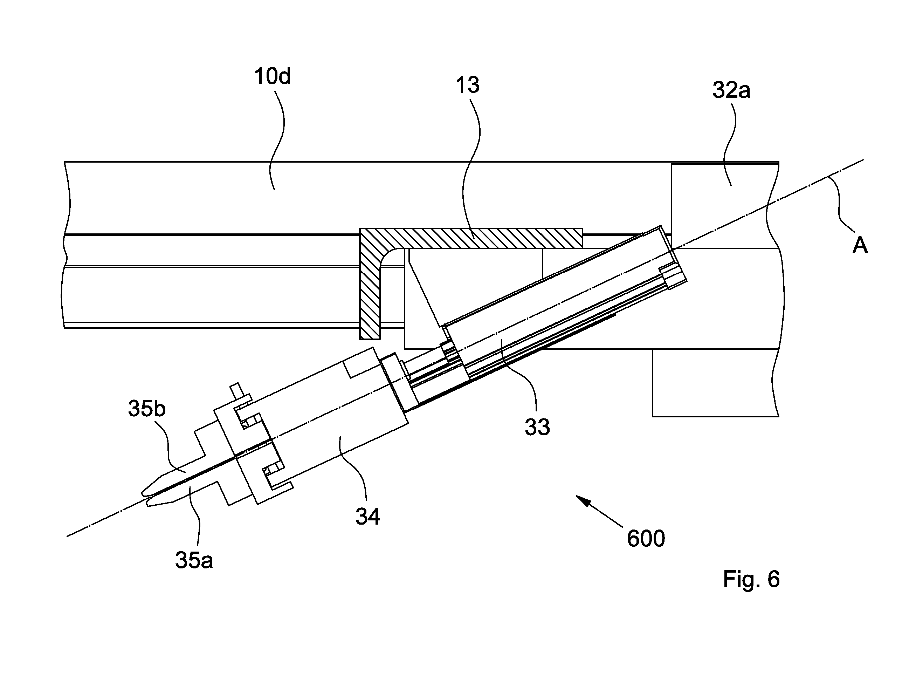

In Fig. 6 ist der erfindungsgemässe Greifer 600 dargestellt. Er ist an dem Balken 13 in besagtem ca. 30-grädigen Winkel angeordnet und weist eine vorzugsweise pneumatisch betriebene Schlitteneinheit 33 auf, mittels der der Greifer 600 entlang seiner Längsachse A verstellbar ist. An einem Greifer-Kopf 34 sind Greifer-Backen 35a und 35b angeordnet, die sich vorzugsweise auch pneumatisch gegenläufig öffnen und schliessen lassen.

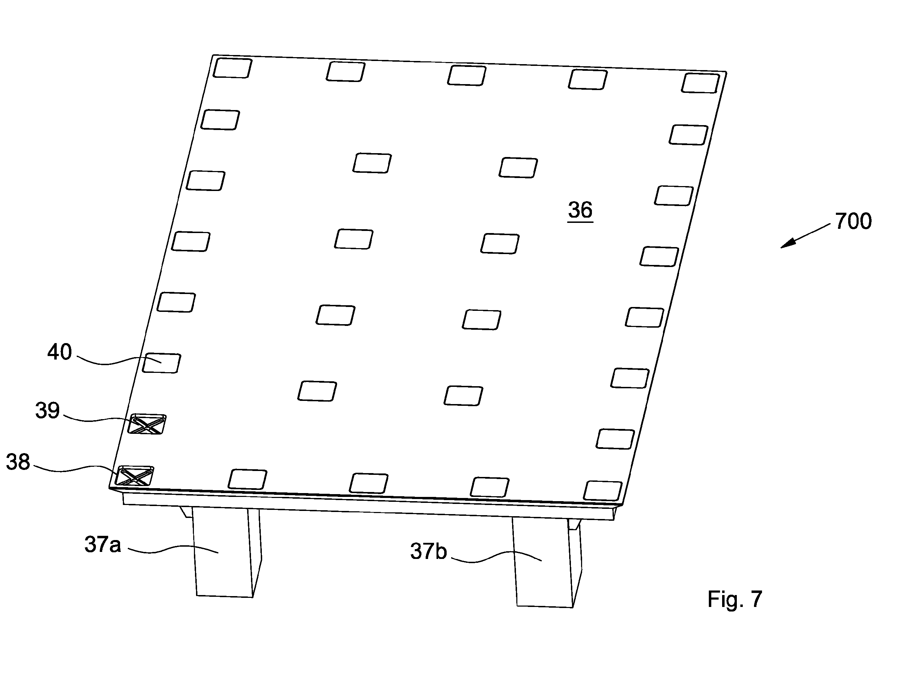

Die Fig. 7 zeigt den erfindungsgemässen Schneidetisch 700, der eine Schneidetisch-Platte 36 umfasst. Letztere steht auf Füssen 37a und 37b, die in dieser perspektivischen Darstellung im Gegensatz zu zwei weiteren, symmetrisch angeordneten, aber verdeckten, nur sichtbar sind. In die Schneidetisch-Platte 36 sind Ausnehmungen 38 eingearbeitet. Diese Ausnehmungen 38 sind mit einem Saugkanal 39 versehen, sodass ein darüber eingesetztes Saugstück 40 aus vorzugsweise porösem Material ein rutschsicheres Aufliegen der zuzuschneidenden Laminier-Folie garantiert.

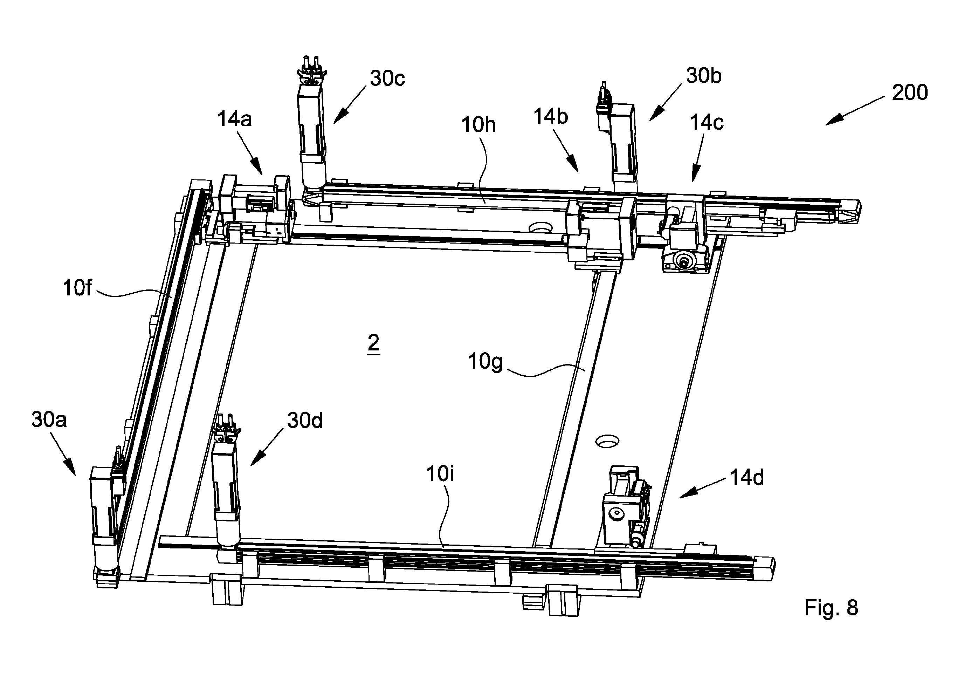

In Fig. 8 ist die erfindungsgemässe Zuschneide-Einheit 200 dargestellt. Die auf dem hier nicht sichtbaren Schneidetisch aufliegende Laminier-Folie 2 wird an ihrer linken Seite von dem Schneidekopf 14a geschnitten, der von einem elektrischen Antrieb 30a an einer Führungsschiene 10f angetrieben ist. Der Schneidekopf 14b schneidet entlang einer Führungsschiene 10g, angetrieben durch einen elektrischen Antrieb 30b; der Schneidekopf 14c entlang einer Führungsschiene 10h, angetrieben durch einen elektrischen Antrieb 30c und der durch einen elektrischen Antrieb 30d angetriebene Schneidekopf 14d entlang einer Führungsschiene 10i.

Ausgehend von den hier dargestellten Parkpositionen der Schneideköpfe 14a-14d ist beispielsweise ein simultaner Schnitt aller vier Schneidekanten des Stückes Laminier-Folie 2 möglich, wenn die Schneideköpfe 14c und 14d starten, sobald der Schneidekopf 14b den Weg für den Schneidekopf 14c freigegeben hat und die Schneideköpfe 14c und 14d mit einer höheren Geschwindigkeit schneiden. Diese höhere Geschwindigkeit muss, zumindest was eine mögliche Kollision zwischen den Schneideköpfen 14b und 14c betrifft, so gewählt sein, dass der Schneidekopf 14c seine Arbeit beendet hat, bevor der Schneidekopf 14b wieder zurück in der gezeigten Parkposition ist.

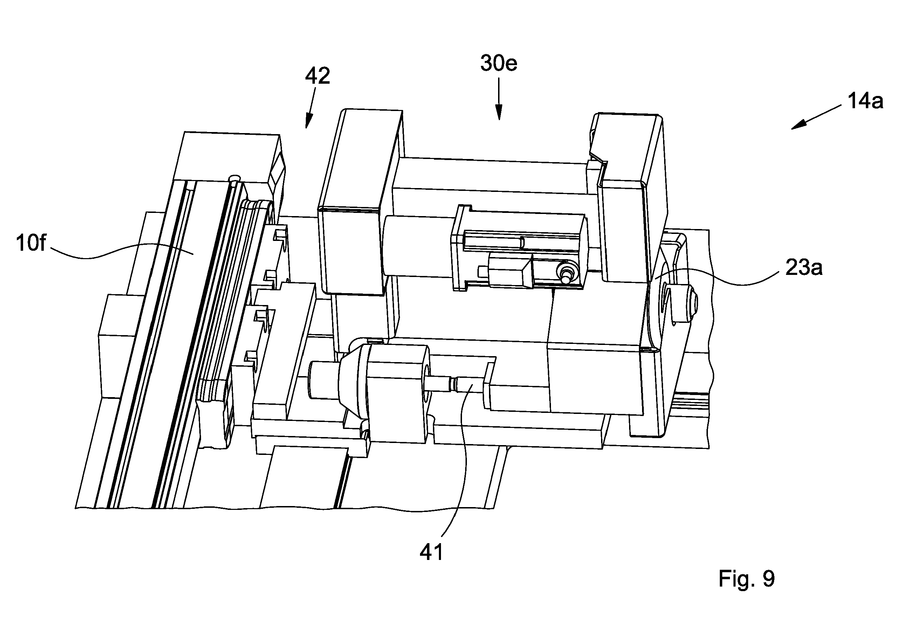

Die Fig. 9 zeigt den Schneidekopf 14a in einer Detaildarstellung. Der Schneidekopf 14a ist mit einer Führung 42 an der Führungsschiene 10f angeordnet. Er weist zudem einen eigenen Antrieb 30e zum Antreiben einer rotierenden Schneidescheibe 23a auf, sowie eine Spindel 41, mittels derer die rotierende Schneidescheibe 23a verstellbar ist.

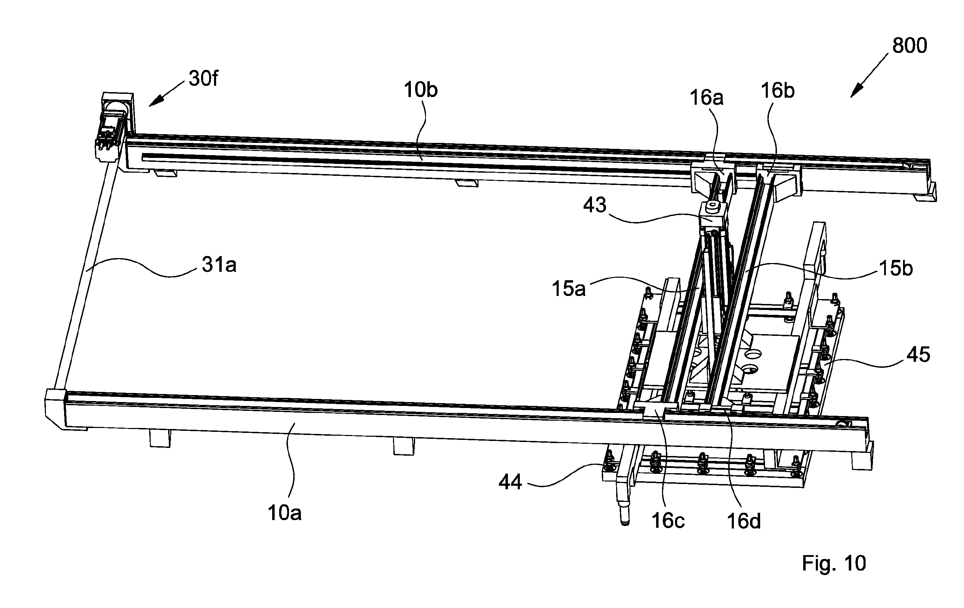

Die Fig. 10 zeigt den erfindungsgemässen Vakuum-Greifer 800, der im Wesentlichen die Streben 15a und 15b, eine Greifer-Platte 45 und einen Pneumatik-Zylinder 43 umfasst. Mit dem Pneumatik-Zylinder 43 ist eine vertikale Verstellung der Greifer-Platte 45 in Z-Richtung gewährleistet. Die Greifer-Platte 45 weist eine Vielzahl von Saugnäpfen 44 auf, die die Laminier-Folie an die Greifer-Platte ansaugen. Ein Antrieb 30f und eine Verbindungswelle 31a stellen sicher, dass der Vakuum-Greifer 800 synchron mit den Führungselementen 16a und 16b in der Führungsschiene 10b und mit den Führungselementen 16c und 16d in der Führungsschiene 10a in X-Richtung verschiebbar ist.

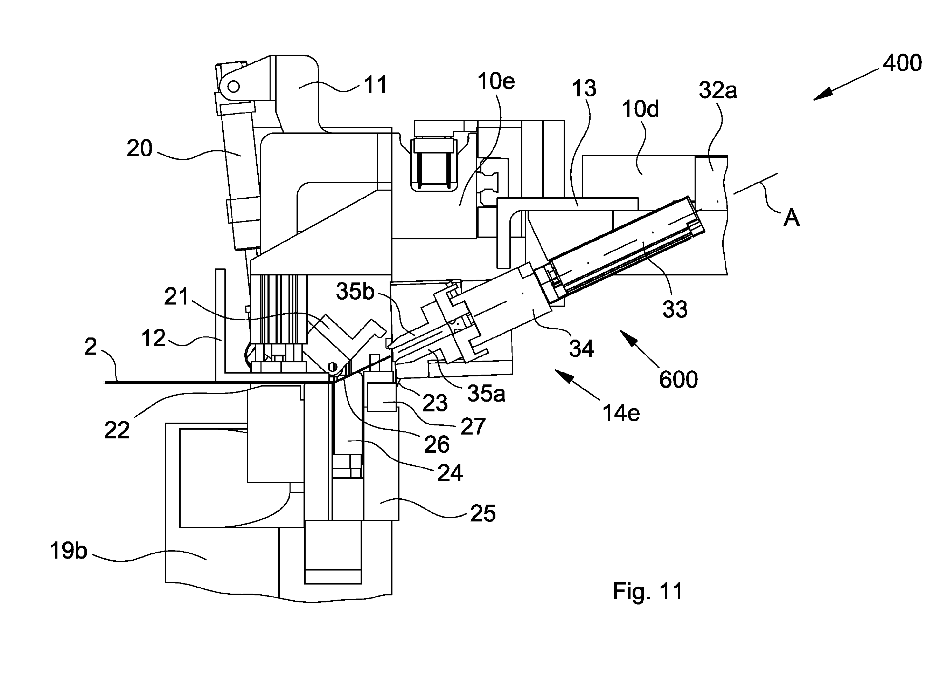

In der Fig. 11 ist die erfindungsgemässe Haltevorrichtung 400 in Kooperation mit dem erfindungsgemässen Greifer 600 dargestellt. Die Laminier-Folie 2 ist durch die rotierende Schneidescheibe 23 abgeschnitten und durch den Hochhalter 24 in eine Aufnahmeposition für den Greifer 600 gedrückt. Der Greifer 600 wird nun mit geöffneten Greifer-Backen 35a und 35b mit Hilfe der Schlitteneinheit 33 entlang seiner Längsachse A über das hochgehaltene Stück Laminier-Folie 2 geschoben.

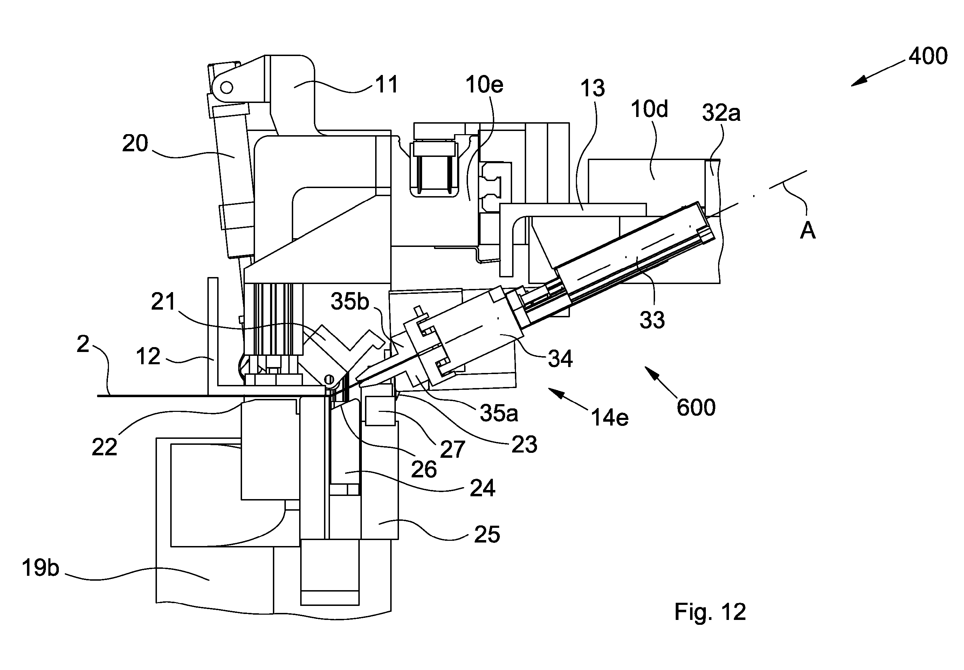

In der Fig. 12 ist der auf die in der Fig. 11 dargestellte Situation nächstfolgende Schritt gezeigt. Der Hochhalter 24 ist zurückgefahren und die Greifer-Backen 35a und 35b haben die Laminier-Folie 2 gefasst. Nun kann ein Auszug der Laminier-Folie 2 in horizontaler X-Richtung erfolgen, indem der Greifer 600, der Balken 13 und der Führungsschuh 32a horizontal an der Führungsschiene 10d verschoben werden.

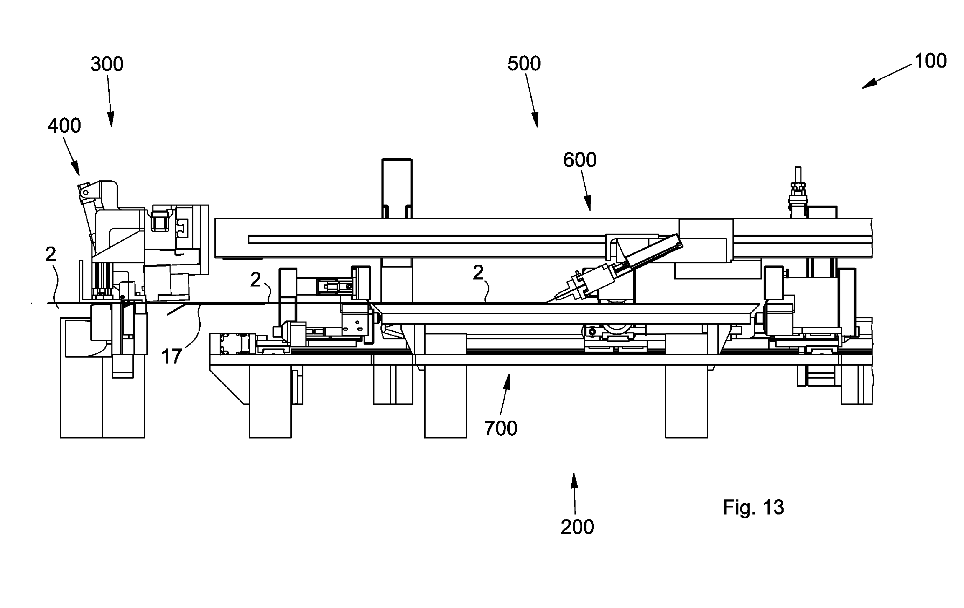

Die Fig. 13 zeigt den Verfahrensschritt des Ausziehens der Laminier-Folie 2 auf den Schneidetisch 700. Der Greifer 600 zieht, wie in der vorangehenden Fig. 12 beschrieben, horizontal die Laminier-Folie 2 durch die nun geöffnete Haltevorrichtung 400, über das Leitblech 17 auf den Schneidetisch 700 und hat in der dargestellten Position schon in etwa den halben Weg zurückgelegt, was einer Stellung entspricht, in der die Auszugs-Einheit 500 innehalten muss und in der die Trenn-Einheit 300 einen erneuten Schnitt vornehmen muss. Auf diese Weise wird das Stück Laminier-Folie 2 so abgelängt, dass es der Breite des Schneidetisches 700 entspricht.

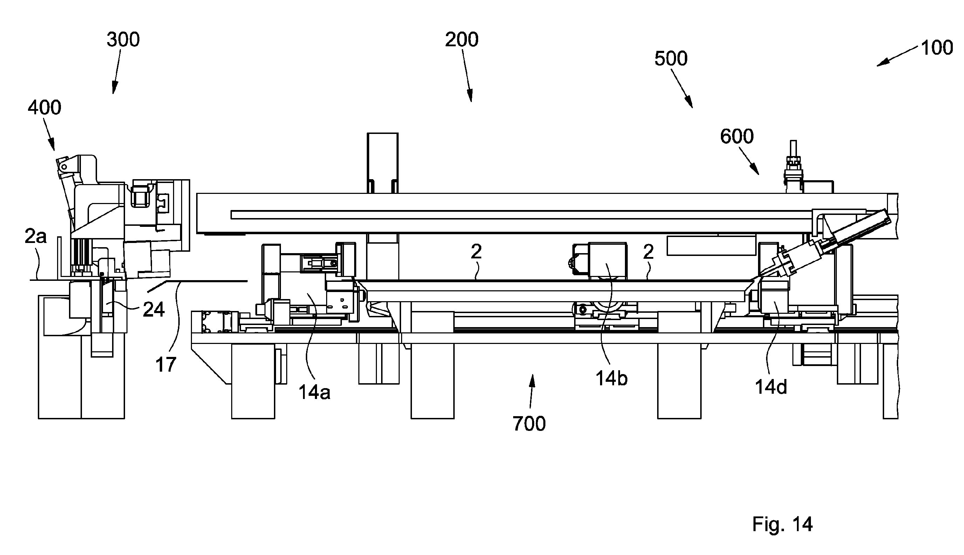

Die Fig. 14 zeigt die Auszugs-Einheit 500 bzw. den Greifer 600 in ihrer/seiner Endposition. Das Stück Laminier-Folie 2 liegt auf dem Schneidetisch 700 auf, wird anschliessend angesaugt und in der Trenn-Einheit 300 ist ein neues Stück Laminier-Folie 2a bereit, um durch den Hochhalter 24 aufgebogen zu werden.

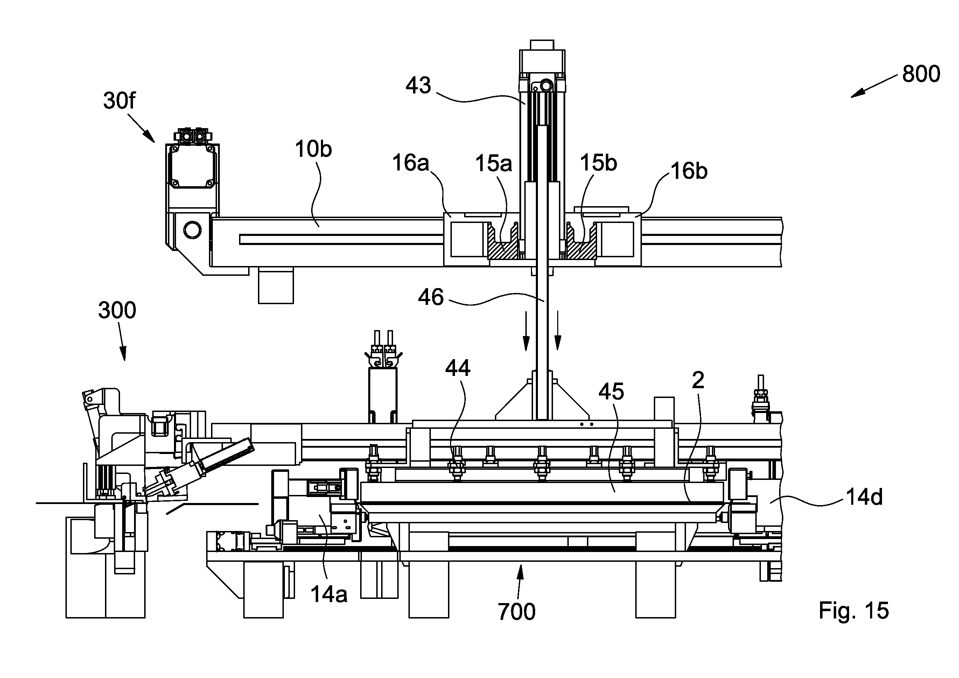

In der Fig. 15 ist der nächstfolgende Bearbeitungsschritt, nämlich das Aufsetzen des Vakuum-Greifers 800 auf die auf dem Schneidetisch 700 liegende Laminier-Folie 2 gezeigt. Eine Kolbenstange 46 fährt hierbei aus dem Pneumatik-Zylinder 43 aus und setzt die Greifer-Platte 45 mit den Saugnäpfen 44 in die Halteposition des Stückes Laminier-Folie 2, in der es im Folgenden zugeschnitten werden wird. In dieser Halteposition ist das Stück Laminier-Folie 2 sowohl durch die - hier nicht sichtbaren - Saugstücke des Schneidetisches 700, als auch durch die Saugnäpfe 44 des Vakuum-Greifers 800 gehalten.

Ein nicht näher dargestelltes, aber weiteres optionales erfindungsgemässes Merkmal ist ein Rahmen, der an der Greifer-Platte 45 des Vakuum-Greifers 800 angeordnet ist. Dieser Rahmen umläuft die Aussenkontur der Auflagefläche der Greifer-Platte 45 und weist Aussenabmessungen auf, die mit den Aussenabmessungen der Auflagefläche des Schneidetisches 700 annähernd identisch sind. Dieser Rahmen erfüllt somit eine mit der Aussenkante des Schneidetisches 700 bündige und positionsgenaue, zusätzliche Haltefunktion des Stückes Laminier-Folie 2.

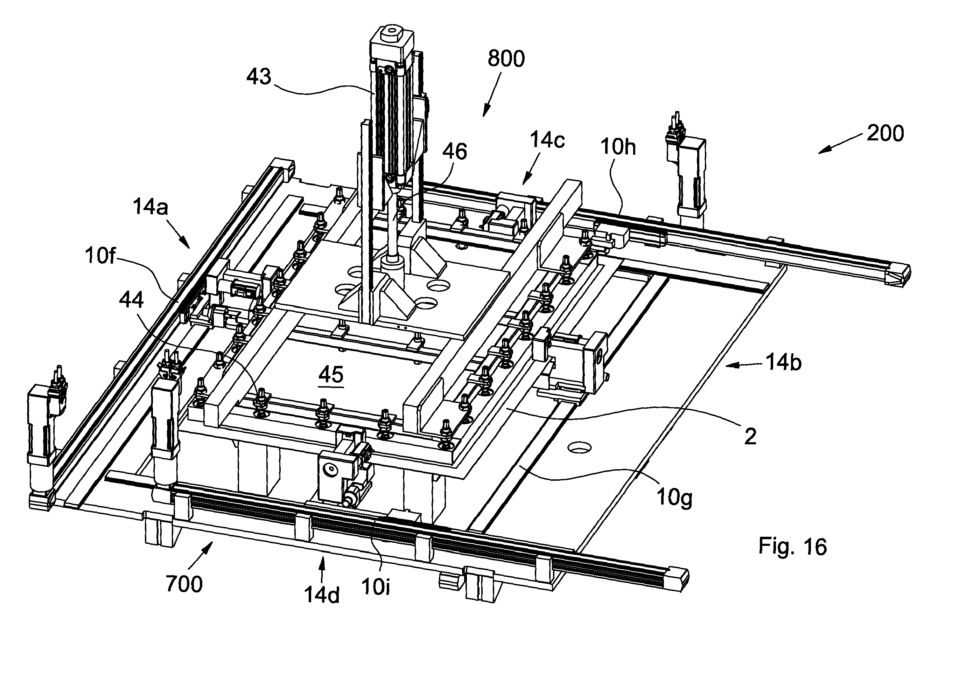

Die Fig. 16 zeigt den nächstfolgenden Bearbeitungsschritt des Zuschneidens des Stückes Laminier-Folie 2 durch die Zuschneide-Einheit 200. Alle vier Schneideköpfe 14a-14d befinden sich simultan in einem Schneidevorgang, der beispielsweise wie in der Beschreibung zu der Fig. 8 offenbart abläuft.

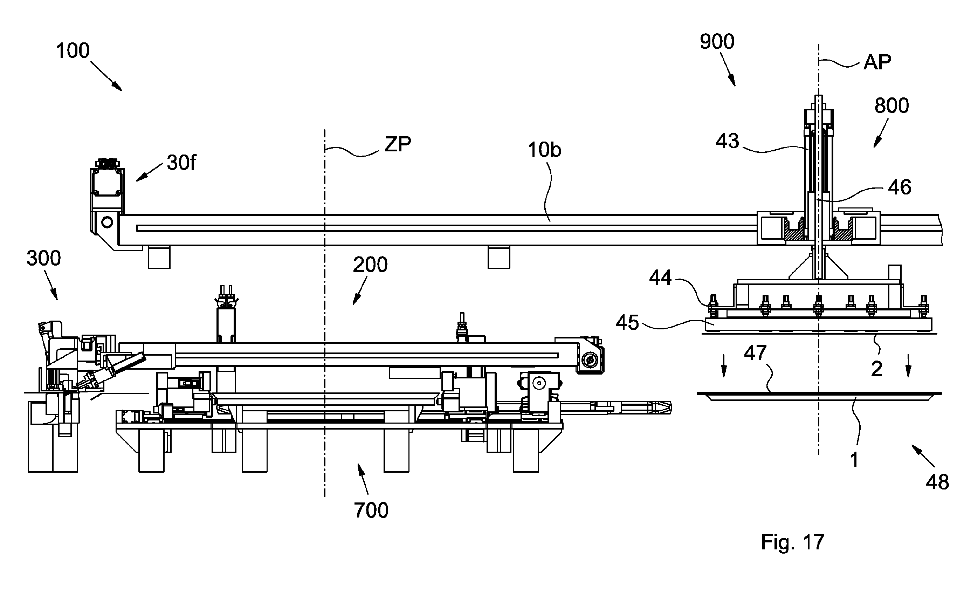

In der Fig. 17 ist dargestellt, dass der Vakuum-Greifer 800 nach erfolgtem Zuschneiden des Stückes Laminier-Folie 2 von dem Schneidetisch 700 - bei gleichzeitigem Abstellen der Saugwirkung der hier nicht näher dargestellten Saugstücke 40 des Schneidetisches 700 das Stück Laminier-Folie 2, noch in der Zuschneide-Position ZP, zuerst durch eine Aufwärtsbewegung der Kolbenstange 46 anheben muss. Anschliessend führt der Vakuum-Greifer 800 eine horizontale Bewegung entlang der Führungsschiene 10b aus, bis er in die Auflege-Position AP oberhalb der Trägerplatte 1 mit einer applizierten Versiegelung 47 angelangt ist. Durch eine Abwärtsbewegung der Kolbenstange 46 wird die Greifer-Platte 45 mit der fertig zugeschnittenen und angesaugten Laminier-Folie 2 abgesenkt, die Saugwirkung der Saugnäpfe 44 wird abgestellt bzw. optional durch Anlegen eines Überdruckes ersetzt und somit das Stück Laminier-Folie 2 positionsgenau auf die Trägerplatte 1 aufgelegt. Anschliessend führt die Kolbenstange 46 erneut eine Aufwärtsbewegung aus, gefolgt von einer nach links gerichteten, horizontalen Rückstellbewegung des Vakuum-Greifers 800 entlang der Führungsschiene 10b. Nicht näher dargestellt ist der nun folgende und letzte Bearbeitungsschritt des Auflegens der Deckplatte 3 mittels des Wendemoduls 5, siehe Fig. 1. Nach diesem Bearbeitungsschritt ist an der Auflege-Position AP ein Solarmodul 48 kaschiert und zum Weitertransport durch das Transportsystem 4b bereit.

## Patentansprüche

1. Vorrichtung (100) zum Kaschieren eines Solarmoduls (48), mit einer Zuschneide-Einheit (200) zum Zuschneiden von Laminier-Folie (2), mit einem Schneidetisch (700) zum Halten der Laminier-Folie (2) in einer Zuschneide-Position (ZP) beim Zuschneiden mit mindestens einem Messer (14, 23), und mit einer Auflege-Einheit (900), **dadurch gekennzeichnet, dass** die Auflege-Einheit (900) einen Greifer zum Halten der Laminier-Folie (2) in der Zuschneide-Position (ZP) auf dem Schneidetisch (700) beim Schneiden umfasst, und **dass** die Auflege-Einheit (900) zum Verfahren mit einer zugeschnittenen Laminier-Folie (2) in eine Auflege-Position (AP) und zum Auflegen der zugeschnittenen Laminier-Folie (2) in der Auflege-Position (AP) auf eine Trägerplatte (1) ausgelegt ist.

2. Vorrichtung (100) nach Anspruch 1, **dadurch gekennzeichnet, dass** die Auflege-Einheit (900) einen Vakuum-Greifer (800) aufweist, der an Führungsschienen (10a, 10b) zwischen der Zuschneide-Position (ZP) und der Auflege-Position (AP) verfahrbar ist.

3. Vorrichtung (100) nach Anspruch 2, **dadurch gekennzeichnet, dass** an einer Auflagefläche des Vakuum-Greifers (800) ein ihre Aussenkontur umlaufender Rahmen angeordnet ist, dessen Aussenabmessungen annähernd identisch mit den Aussenabmessungen einer Auflagefläche des Schneidetisches (700) sind, und **dass** durch die Zuschneide-Einheit (200) ein freier Schnitt an einer Schneidetischkante des Schneidetischs (700) entlang ausführbar ist.

4. Vorrichtung (100) nach einem der vorhergehenden Ansprüche, **dadurch gekennzeichnet, dass** die Zuschneide-Einheit (200) vier Schneideköpfe (14a-14d) umfasst, die simultan ein Stück Laminier-Folie (2) zuschneiden.

5. Vorrichtung (100) nach Anspruch 4, **dadurch gekennzeichnet, dass** eine Schneidebewegung der Schneideköpfe (14a-14d) vorzugsweise programmierbar steuerbar ist und den Schneideköpfen (14a-14d) Parkpositionen zuweisbar sind.

6. Vorrichtung (100) nach Anspruch 4 oder 5, **dadurch gekennzeichnet, dass** ein Messer (23) oder ein Laserkopf mindestens eines Schneidekopfes (14a-14d) mit einer Spindel (41) verstellbar ist.

7. Vorrichtung (100) nach einem der vorhergehenden Ansprüche, **dadurch gekennzeichnet, dass** die Zuschneide-Einheit (200) weitere Messer (23) oder mindestens einen Laserkopf oder eine Stanzvorrichtung umfasst, mit der Ecken eines zugeschnittenen Stückes Laminier-Folie (2) abrundbar sind bzw. Löcher oder Ausnehmungen in ein Stück Laminier-Folie (2) schneid- bzw. stanzbar sind.

8. Vorrichtung (100) nach einem der vorhergehenden Ansprüche, **dadurch gekennzeichnet, dass** eine Auszugs-Einheit (500) vorgesehen ist, die von einer Aufnahme-Position der Laminier-Folie (2) an einer Trenn-Einheit (300) bis zu der Zuschneide-Position (ZP) auf dem Schneidetisch (700) in linearen Führungsschienen (10c, 10d) verfahrbar ist.

9. Vorrichtung (100) nach einem der vorhergehenden Ansprüche, **dadurch gekennzeichnet, dass** der Schneidetisch (700) Saugstücke (40) aus vorzugsweise porösem Material aufweist.

10. Vorrichtung (100) nach einem der vorhergehenden Ansprüche 4-9, **dadurch gekennzeichnet, dass** die Schneideköpfe (14a-14d) der Zuschneide-Einheit (200) bzw. Führungen (10f-10i) für die Schneideköpfe (14a-14d) in Seitenwände des Schneidetisches (700) integriert sind.

11. Vorrichtung (100) nach einem der vorhergehenden Ansprüche 5-10, **dadurch gekennzeichnet, dass** in eine programmierbare Steuerung für die Schneideköpfe (14a-14d) Dateninformationen einer Kamera eingebbar sind.

12. Verfahren zum Kaschieren eines Solarmoduls (48) mit folgenden Schritten:
- Ansaugen einer Laminier-Folie (2) an eine Schneidetisch-Platte (36) eines Schneidetisches (700);
- Halten der Laminier-Folie (2) mittels eines verfahrbaren Vakuum-Greifers (800) in einer Zuschneide-Position (ZP);
- Zuschneiden der Laminier-Folie (2);
- Abstellen der Saugwirkung an der Schneidetisch-Platte (36) des Schneidetisches (700);
- Verfahren des zugeschnittenen Stückes Laminier-Folie (2) mit dem Vakuum-Greifer (800) aus der Zuschneide-Position (ZP) in eine Auflege-Position (AP) an einer Trägerplatte (1);
- Auflegen des zugeschnittenen Stückes Laminier-Folie (2) auf die Trägerplatte (1) durch Herabsenken des Vakuum-Greifers (800);
- Abstellen der Saugwirkung des Vakuum-Greifers (800).

13. Verfahren nach Anspruch 12, **dadurch gekennzeichnet, dass** der Verfahrensschritt des Zuschneidens als simultanes Zuschneiden von vier Kanten der Laminier-Folie (2) mit vier Schneideköpfen (14a-14d) ausgeführt wird.

14. Verfahren nach Anspruch 12 oder 13, **dadurch gekennzeichnet, dass** vor den in Anspruch 12 aufgezählten Verfahrensschritten folgende Verfahrensschritte ausgeführt werden:
- Abrollen der Laminier-Folie (2) von einem Folien-Abroller (6) mittels eines Rollen-Systems (7) auf einen Auflage-Tisch (8);
- Halten der Laminier-Folie (2) auf dem Auflage-Tisch (8) mit einer Haltevorrichtung (400) einer Trenn-Einheit (300);
- Schneiden der Laminier-Folie (2) mit einem Schneidekopf (14e) der Trenn-Einheit (300);
- Fassen einer Schnittkante der Laminier-Folie (2) mit Greifern (600) einer Auszugs-Einheit (500);
- Öffnen der Haltevorrichtung (400) der Trenn-Einheit (300);
- Ausziehen der Laminier-Folie (2) mit der Auszugs-Einheit (500) auf den Schneidetisch (700) bis zu einer einstellbaren Zwischenposition;
- Schliessen der Haltevorrichtung (400) der Trenn-Einheit(300);
- Abtrennen eines Stückes Laminier-Folie (2) durch einen erneuten Schnitt des Schneidekopfes (14e) der Trenn-Einheit (300);
- Öffnen der Haltevorrichtung (400) der Trenn-Einheit (300);
- Ausziehen des Stückes Laminier-Folie (2) mit der Auszugs-Einheit (500) bis in eine Endposition auf den Schneidetisch (700).

15. Verfahren nach Anspruch 14, **dadurch gekennzeichnet, dass** vor dem Verfahrensschritt des Fassens der Schnittkante der Laminier-Folie (2) folgende Verfahrensschritte ausgeführt werden:
- Bördeln bzw. Hochhalten der Schnittkante der Laminier-Folie (2) durch eine Aufwärtsbewegung eines Hochhalters (24) der Trenn-Einheit (300);
- Absenken des Hochhalters (24) der Trenn-Einheit 300).

16. Verfahren nach Anspruch 12, **dadurch gekennzeichnet, dass** das Zuschneiden der Laminier-Folie (2) mit einem freien Schnitt entlang einer Schneidetischkante des Schneidetischs (700) erfolgt.
